# FASCICULE DE BREVET EUROPEEN

(11) **EP 2 011 763 B1**
(45) Date de publication et mention de la délivrance du brevet: **14.09.2011**
(21) Numéro de dépôt: 07111580.2
(22) Date de dépôt: 03.07.2007
(51) Int. Cl.: B81C 99/00, B81C 1/00

(54) **Procédé de fabrication de pièces micromécaniques en matériau cristallin**
Verfahren zur Herstellung von mikromechanischen Teilen aus kristallinischem Material
Method of producing micromechanical parts with crystalline material

(43) Date de publication de la demande: 07.01.2009
(73) Titulaire: EM Microelectronic-Marin SA, 2074 Marin (CH)
(72) Inventeur: Gonin, Yvan, 2316 Les Ponts de Martel (CH); Marsico, Vittorio, 2088 Cressier (CH)
(74) Mandataire: Ravenel, Thierry Gérard Louis

(56) Documents cités:
- EP-A- 1 722 281
- A. PERRET: "Le Silicium Comme Matériau Dans La Fabrication De Pièces Mécaniques" BULLETIN SOCIÉTÉ SUISSE DE CHRONOMÉTRIE, no. 38, 9 novembre 2001 (2001-11-09), pages 27-29, XP002460036 Neuchâtel

## Description

L'invention se rapporte au domaine de la microtechnique. Elle concerne plus particulièrement un procédé de fabrication de pièces mécaniques ou micromécaniques en silicium, ou tout autre matériau compatible avec les technologies de fabrication des semi-conducteurs.

Des pièces mécaniques ou micromécaniques en silicium sont connues de l'homme de métier. Ce sont, par exemple, des pièces d'horlogerie telles que des roues, des aiguilles, des spiraux, des ancres ou tout autre pièce essentiellement plane. Ces pièces présentent des propriétés mécaniques intéressantes, telles qu'une résistance importante à l'usure ou un faible coefficient de frottement. Elles sont généralement fabriquées à partir de substrats du type 'silicium sur isolant' (de l'anglais SOI 'silicon on insulator'), formés d'une plaquette de silicium, d'une couche d'isolant enterrée, telle qu'une couche d'oxyde ou de saphir, et d'une couche de silicium superficielle d'épaisseur quelques dizaines à quelques centaines de microns. La fabrication comporte plusieurs étapes faisant intervenir des procédés développés pour l'industrie des circuits intégrés. Ces procédés permettent de réaliser des pièces de formes complexes dans le plan, avec une précision supérieure à la précision obtenue par étampage.

Le document "Le Silicium Comme Matériau Dans la Fabrication De Pièces Mécaniques", A. PERRET, BULLETIN SOCIÉTÉ SUISSE DE CHRONOMÉTRIE, no. 38, 9 novembre 2001, pages 27-29, présente un exemple de ces procédés.

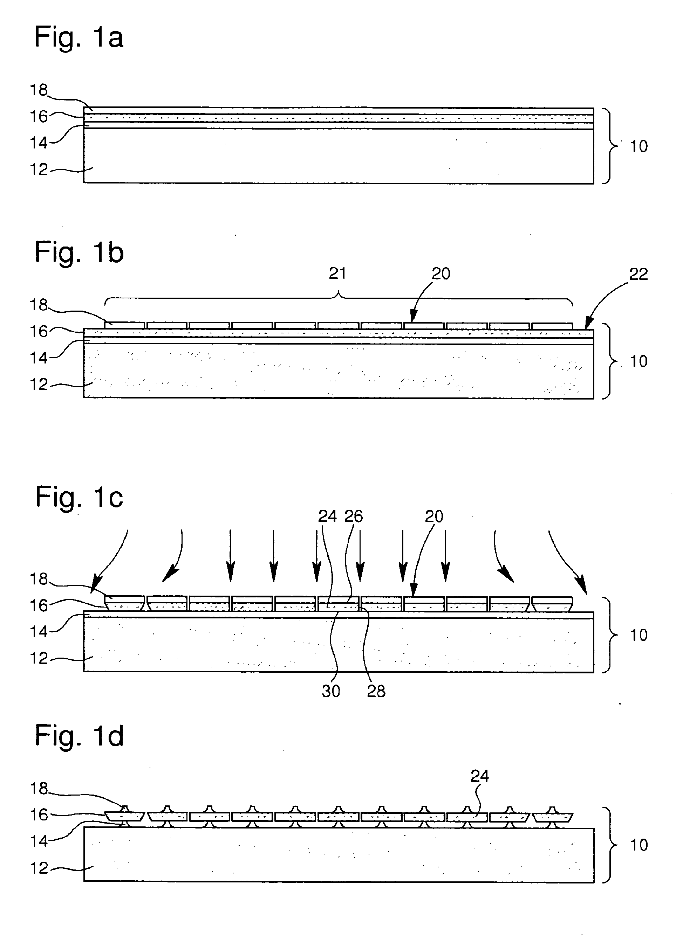

Les principales étapes de la fabrication d'une pièce mécanique en silicium à partir d'un substrat comportant une couche superficielle en silicium, du type 'silicium sur isolant', sont illustrées schématiquement en figure 1. Afin de faciliter la représentation et la lecture, les échelles n'ont volontairement pas été respectées.
- Figure 1a : Un substrat 10 formé d'une plaquette de silicium 12, d'une couche enterrée d'oxyde 14 et d'une couche superficielle de silicium 16, est oxydé pleine face. Une couche superficielle d'oxyde 18, s'étendant sur la totalité de la couche superficielle de silicium 16 et d'épaisseur typiquement 1 micron, sensiblement uniforme, est ainsi obtenue. Le procédé d'oxydation est généralement un procédé thermique, sec ou humide. En variante, il pourrait s'agir d'un procédé d'oxydation par dépôt, de type physico-chimique, tel qu'un dépôt en phase vapeur assisté par plasma (en anglais PECVD 'Plasma Enhanced Chemical Vapor Deposition').
- Figure 1b : La couche superficielle d'oxyde 18 est structurée par photolithographie de façon à former un masque d'oxyde 20. Une telle étape de structuration comprend une première sous-étape de couchage d'une résine photosensible, une deuxième sous-étape d'exposition locale de la résine aux rayons ultra-violets, une troisième sous-étape de durcissement de la résine, une quatrième sous-étape de développement de la résine, une cinquième sous-étape de gravure de l'oxyde à travers le masque de résine, par un procédé humide ou sec, puis une sixième sous-étape de nettoyage de la résine. Toutes ces sous-étapes sont classiques, et ne seront pas décrites dans le détail, étant bien connues de l'homme de métier.

On notera que la sous-étape de couchage de résine se termine par une opération d'enlèvement de la résine sur le pourtour de la couche superficielle d'oxyde 18. Cette opération est réalisée notamment à l'aide d'un jet de solvant dirigé vers le bord du substrat 10, sur une largeur de 2 à 5 millimètres. Elle a pour effet d'exposer le pourtour de la couche superficielle d'oxyde 18 à la gravure, et ainsi de dénuder le pourtour de la couche superficielle de silicium 16, en fin de gravure. Le substrat 10 présente donc, après formation du masque 20, une zone centrale 21 recouverte essentiellement d'oxyde, et une zone périphérique 22, sur laquelle le silicium est dénudé.

L'opération d'enlèvement de résine en pourtour de substrat est classique dans le cadre de la fabrication des circuits intégrés. Elle a pour objet d'éliminer sur cette zone, toutes les couches déposées, afin d'éviter la formation d'un bourrelet périphérique constitué de l'empilement de couches diverses. Un tel bourrelet est à l'origine de problèmes de pelage, de court-circuits, de préhension et de maintien des substrats.

Une telle opération d'enlèvement de résine en pourtour de substrat n'est pas nécessaire dans le cadre de la fabrication de pièces mécaniques. En effet, le nombre d'étapes de fabrication est, dans ce cas, réduit, et ne donne pas lieu à la formation d'un bourrelet. Toutefois, l'opération d'enlèvement de résine ne peut être facilement éliminée pour les raisons suivantes : Les pièces mécaniques en silicium sont généralement fabriquées dans les lignes de fabrication des circuits intégrées. Les procédés sont adaptés pour la fabrication de circuits intégrés, et il est long et coûteux de les modifier au passage de lots de pièces mécaniques. De plus, la présence de résine sur le pourtour des substrats pose des problèmes sérieux de contamination. En effet, le contact avec les dispositifs de préhension des substrats se fait par le pourtour du substrat. Si celui-ci est recouvert de résine, le dispositif de préhension se charge en résine et celle-ci s'accumule progressivement jusqu'à se décoller et se déposer au hasard sur les substrats. Les pièces contaminées par la résine sont défectueuses et doivent être rejetées. Pour ces raisons, l'opération d'enlèvement de résine est obligatoire en fin de couchage de résine, pour les lots de pièces mécaniques, comme pour les lots de circuits intégrés.
- Figure 1c : La couche superficielle de silicium 16 est gravée à travers le masque d'oxyde 20, jusqu'à la couche enterrée d'oxyde 14, de façon à former des pièces mécaniques 24 en silicium, comportant une face supérieure 26, un flanc 28, et une face inférieure 30. A ce stade de la fabrication, les faces supérieure 26 et inférieure 30 sont encore solidaires respectivement des couches d'oxyde superficielle 18 et enterrée 14.

Le procédé de gravure utilisé pour l'attaque de la couche de silicium superficielle est hautement sélectif, c'est-à-dire qu'il attaque fortement le silicium et faiblement l'oxyde, de façon à ce que la définition des pièces de silicium soit optimale. Il est, par ailleurs, hautement anisotrope, c'est-à-dire apte à attaquer la couche superficielle de silicium 16 perpendiculairement au plan du substrat 10 et non pas parallèlement. Une gravure anisotrope est indispensable pour que les flancs 28 des pièces mécaniques 24 soient perpendiculaires à leurs faces supérieure 26 et inférieure 30.

Un tel procédé de gravure, sélectif et anisotrope, est généralement de type physico-chimique. La gravure ionique réactive (de l'anglais RIE 'Reactive Ion Etching') est le plus souvent utilisée. Il s'agit d'une gravure en phase gazeuse assistée par plasma. Le gaz est généralement un gaz fluoré, comme le SF₆, le CF₄ ou le CHF₃. Le plasma a pour effet de créer des espèces réactives et de les accélérer perpendiculairement au substrat 10. En figure 1c, le plasma est représenté par des flèches dirigées perpendiculairement au substrat 10, référencées 30.

Dans le procédé standard de fabrication des pièces mécaniques, la zone de silicium périphérique dénudée 22 est exposée au plasma 30 pendant toute la durée de la gravure. Cette zone 22 forme, au regard du plasma 30, une discontinuité chimique par rapport à la zone centrale 21, recouverte d'oxyde. Une inhomogénéité du plasma 30 se crée alors au voisinage de la transition entre les zones centrale 21 et périphérique 22. Cette inhomogénéité locale a pour effet de perturber la gravure au voisinage de la zone périphérique 22, et en particulier son caractère anisotrope. On observe que les pièces mécaniques 24 situées au voisinage de la zone périphérique 22, présentent des flancs 28 non pas perpendiculaires aux faces supérieure 26 et inférieures 30, mais obliques, soit rentrants, soit sortants. Ces pièces doivent être rejetées car elles présentent des risques d'usure prématurée et non uniforme. A terme, cette usure peut provoquer une rupture brutale de la pièce.
- Figure 1d : Les couches superficielle 18 et enterrée 14 d'oxyde sont éliminées par voie humide, généralement par attaque dans un bain d'acide fluorhydrique concentré. Les pièces en silicium 24 sont ainsi libérées du substrat 10.

Le procédé de fabrication de pièces mécaniques en silicium ainsi décrit, est le procédé selon l'état de la technique. Il conduit au rejet de pièces périphériques représentant un pourcentage de l'ordre de 10 à 30 pourcents du nombre de pièces total, selon la taille des pièces. La présente invention a pour objet de remédier à ce problème de rejet, de façon simple et efficace. Plus précisément, l'invention concerne un procédé de fabrication de pièces en un premier matériau apte à être gravé, à partir d'un substrat comportant au moins une couche superficielle de ce premier matériau. Selon l'invention, ce procédé comporte les étapes suivantes :
- Formation d'une couche superficielle sensiblement uniforme d'un deuxième matériau en surface de la couche superficielle du premier matériau, le deuxième matériau étant apte à résister à une gravure sélective du premier matériau,
- Formation d'un bourrelet du deuxième matériau en pourtour de la couche superficielle du deuxième matériau,
- Structuration de la couche du deuxième matériau et du bourrelet par un procédé standard de photolithographie comprenant une étape de gravure d'une durée suffisante pour graver la couche superficielle du deuxième matériau sur toute son épaisseur, mais insuffisante pour graver le bourrelet sur toute son épaisseur, de façon à obtenir un masque du deuxième matériau s'étendant jusqu'en périphérie de la couche de premier matériau,
- Découpe des pièces en premier matériau à travers le masque du deuxième matériau, par attaque directionnelle.

Grâce à l'étape de formation d'un bourrelet du deuxième matériau en bord de substrat, le masque dudit deuxième matériau s'étend jusqu'en périphérie de la couche superficielle du premier matériau, de sorte que l'inhomogénéité du plasma est éliminée.

D'autres caractéristiques et avantages de la présente invention ressortiront plus clairement de la description détaillée qui suit d'un exemple de réalisation du procédé de fabrication selon l'invention, cet exemple étant donné à titre purement illustratif et non limitatif seulement, en liaison avec le dessin annexé sur lequel :

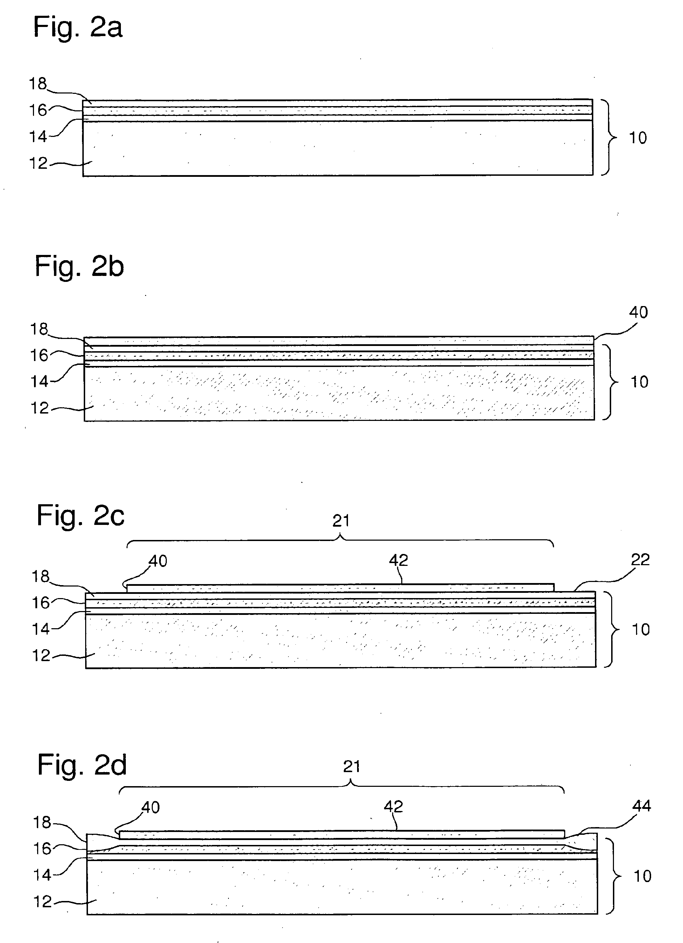

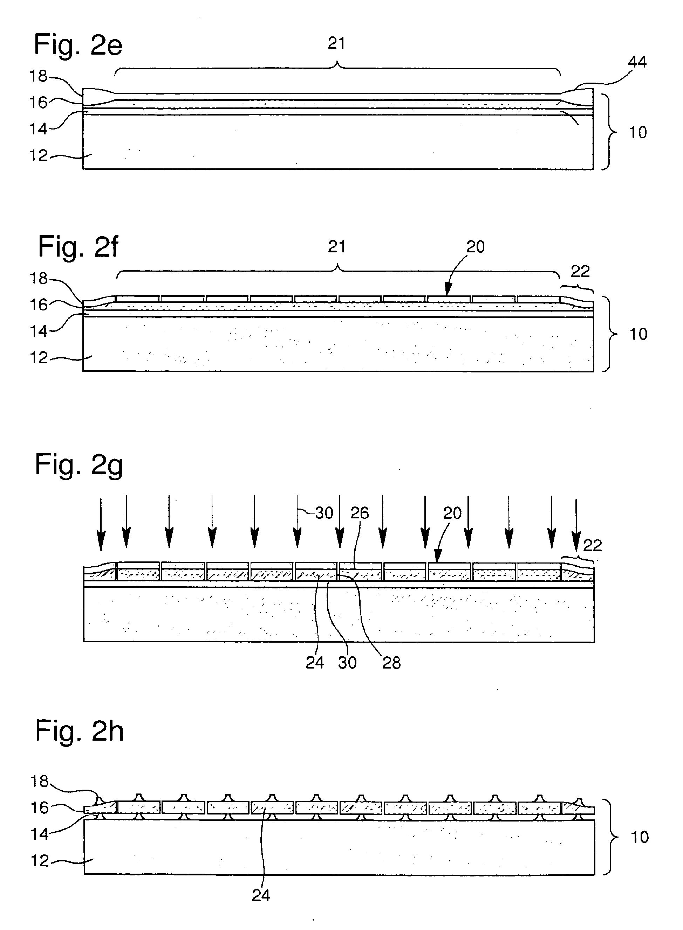

- la figure 2 représente schématiquement les principales étapes d'un procédé de fabrication de pièces mécaniques en silicium selon l'invention.

On notera que, comme en figure 1, les échelles n'ont volontairement pas été respectées, afin de faciliter la lecture et la représentation.
- Figure 2a : Un substrat 10 formé d'une plaquette de silicium 12, d'une couche enterrée d'oxyde 14 et d'une couche superficielle de silicium 16, est oxydé pleine face. Une couche superficielle d'oxyde 18, s'étendant sur la totalité de la couche superficielle de silicium 16 et d'épaisseur typiquement 1 micron, sensiblement uniforme, est ainsi obtenue. Cette étape ne diffère pas de la première étape, illustrée en figure 1a, du procédé selon l'état de la technique.
- Figure 2b : Une couche de nitrure 40 d'épaisseur environ 0.2 micron est déposée pleine face sur la couche superficielle d'oxyde 18. Le procédé utilisé est généralement un procédé de 'dépôt chimique en phase vapeur à basse pression' (de l'anglais LPCVD 'Low Pressure Chemical Vapor Deposition'). En variante, il pourrait s'agir d'un procédé de 'dépôt en phase gazeuse assisté par plasma' (de l'anglais PECVD 'Plasma Enhanced Chemical Vapor Deposition').
- Figure 2c : La couche de nitrure 40 est structurée de manière à former un masque 42 s'étendant sur toute la zone centrale 21 du substrat 10, et laissant exposée la zone périphérique 22. Une telle étape de structuration comprend une première sous-étape de couchage d'une résine photosensible, une éventuelle deuxième sous-étape d'exposition de la résine aux rayons ultra-violets, une troisième sous-étape de durcissement de la résine, une quatrième sous-étape de gravure du nitrure à travers le masque de résine, par un procédé humide ou sec, puis une cinquième sous-étape de nettoyage de la résine. Toutes ces sous-étapes sont classiques, et ne seront pas décrites dans le détail, étant bien connues de l'homme de métier. On notera que la sous-étape de couchage d'une résine photosensible est classiquement terminée par une opération d'enlèvement de la résine sur le pourtour de la couche de nitrure 40.
- Figure 2d : Le substrat 10 ainsi recouvert d'une couche superficielle d'oxyde 18 et d'un masque de nitrure 42, est oxydé. L'oxydation se fait sélectivement, c'est-à-dire qu'elle se produit sur la zone périphérique 22 et non pas sur la zone centrale 21, en raison de la présence du masque de nitrure 42 qui bloque la réaction d'oxydation là où il recouvre la couche superficielle d'oxyde 18. Le procédé d'oxydation est de type thermique, de préférence humide. Il donne lieu à la formation d'un bourrelet d'oxyde périphérique 44, d'épaisseur 2 à 3 microns, soit environ deux à trois fois l'épaisseur de la couche superficielle d'oxyde 18, et de largeur 3 à 8 millimètres.
- Figure 2e : Le masque de nitrure 42 est éliminé par voie chimique, typiquement dans un bain d'acide orthophosphorique. Le substrat 10 est, à ce stade, recouvert par la couche superficielle d'oxyde 18 et le bourrelet d'oxyde 44.
- Figure 2f : La couche superficielle d'oxyde 18 est structurée par photolithographie de façon à former un masque d'oxyde 20. Cette étape est
similaire à l'étape de structuration selon l'état de la technique représentée en figure 1b, et comprend les mêmes sous étapes.

Comme dans le procédé standard, la sous-étape de couchage de résine se termine par une opération d'enlèvement de la résine sur le pourtour de la couche superficielle d'oxyde 18, c'est-à-dire sur le bourrelet d'oxyde 44. Elle a pour effet d'exposer le bourrelet d'oxyde 44 à la gravure de l'oxyde. Toutefois, l'épaisseur du bourrelet et la durée de la gravure sont prévues pour qu'en fin de gravure, la couche superficielle d'oxyde soit attaquée sur toute son épaisseur et que le bourrelet 44 ne soit pas éliminé, mais seulement aminci jusqu'à environ un tiers de son épaisseur initiale. Pour un bourrelet 44 d'épaisseur environ deux à trois fois l'épaisseur de la couche superficielle d'oxyde 18, la durée de la gravure peut atteindre un et demi à deux fois la durée minimale de gravure de la couche superficielle d'oxyde 18. Ainsi, en fin de structuration de la couche superficielle d'oxyde 18, le substrat 10 présente une zone centrale 21 recouverte essentiellement d'oxyde, et une zone périphérique 22 recouverte intégralement d'oxyde. Il n'y a pas de discontinuité entre la zone centrale 21 et la zone périphérique 22.
- Figure 2g : La couche superficielle de silicium 16 est gravée à travers le masque d'oxyde 20, jusqu'à la couche enterrée d'oxyde 14, de façon à découper des pièces mécaniques 24 en silicium, comportant une face supérieure 26, un flanc 28, et une face inférieure 30. Le procédé de gravure est semblable au procédé utilisé pour le procédé de fabrication de pièce mécanique selon l'état de la technique.

Contrairement à ce qui se produit dans le procédé standard de fabrication des pièces mécaniques, la zone périphérique 22, exposée à la gravure plasma au même titre que la zone centrale 21, est recouverte d'oxyde. Il y a continuité chimique entre la zone périphérique 22 et la zone centrale 21. Le plasma est, par conséquent, homogène sur l'intégralité de la surface exposée au plasma, et aucune perturbation de la gravure n'est observée. Il en résulte que les pièces voisines de la zone périphérique 22 sont conformes, c'est-à-dire que leurs flancs 28 sont perpendiculaires à leurs faces supérieure 26 et inférieure 30. Aucun rejet lié à la géométrie des pièces n'est constaté.
- Figure 2h . Les couches superficielle 18 et enterrée 14 d'oxyde sont éliminées par voie humide, généralement par attaque dans un bain d'acide fluorhydrique concentré. Les pièces en silicium 24 sont ainsi libérées.

Ainsi a été décrit un procédé de fabrication de pièces mécaniques en silicium, à partir d'un substrat de type silicium sur isolant. Il va de soi que la présente invention n'est pas limitée au mode de réalisation qui vient d'être décrit, et que diverses modifications et variantes simples peuvent être envisagées par l'homme de métier, sans sortir du cadre de la présente invention telle que définie par les revendications annexées. On notera en particulier que les types de procédés de gravure, d'oxydation, de dépôt mentionnés, sont donnés à titre indicatif. D'autres types de procédés bien connus de l'homme de métier peuvent être employés en lieu et place des procédés cités, sans sortir du cadre de la présente invention.

On notera également que le procédé selon l'invention peut s'appliquer à des matériaux variés, autres que le silicium. Le procédé peut, en particulier, être transposé sans adaptation majeure, à d'autres matériaux semi-conducteurs tels que le germanium. Il convient également au quartz SiO₂, mais il nécessite, dans ce cas, quelques adaptations. En effets, le quartz ne peut être oxydé, et par conséquent, la couche superficielle d'oxyde 18 doit être remplacée par une couche superficielle d'un autre matériau, apte à résister à une étape de gravure du quartz. Ce matériau est, par exemple, du nitrure ou du polysilicium. La couche superficielle est réalisée par un procédé de dépôt plutôt que par un procédé de transformation de la couche superficielle de quartz, tel que l'oxydation. Le bourrelet 44 est également obtenu par un dépôt sélectif en périphérie de la couche de nitrure. Le procédé de gravure utilise une chimie apte à graver le quartz sélectivement par rapport au nitrure ou au polysilicium.

## Revendications

1. Procédé de fabrication de pièces (24) en un premier matériau apte à être gravé, à partir d'un substrat (10) comportant au moins une couche superficielle (16) de ce premier matériau, **caractérisé en ce qu'**il comporte les étapes suivantes :
- Formation d'une couche superficielle (18) sensiblement uniforme d'un deuxième matériau en surface de ladite couche superficielle (16) du premier matériau, ledit deuxième matériau étant apte à résister à une gravure sélective du premier matériau,
- Formation d'un bourrelet (44) dudit deuxième matériau en pourtour de ladite couche superficielle (18) dudit deuxième matériau,
- Structuration de la couche (18) du deuxième matériau et du bourrelet (44) par un procédé standard de photolithographie comprenant une étape de gravure d'une durée suffisante pour graver ladite couche superficielle (18) du deuxième matériau sur toute son épaisseur, mais insuffisante pour graver ledit bourrelet (44) sur toute son épaisseur, de façon à obtenir un masque (20) dudit deuxième matériau s'étendant jusqu'en périphérie de ladite couche (16) de premier matériau,
- Découpe desdites pièces en premier matériau à travers ledit masque (20) dudit deuxième matériau, par attaque directionnelle.

2. Procédé de fabrication de pièces (24) selon la revendication 1, **caractérisé en ce que** ledit premier matériau est du silicium.

3. Procédé de fabrication de pièces (24) selon l'une des revendications 1 et 2, **caractérisé en ce que** ledit deuxième matériau est de l'oxyde.

4. Procédé de fabrication de pièces (24) selon les revendications 2 et 3, **caractérisé en ce que** la formation de la couche superficielle (18) d'oxyde en surface de la couche superficielle de silicium (16) est réalisée par un procédé d'oxydation pleine face de ladite couche superficielle de silicium (16).

5. Procédé de fabrication de pièces (24) selon la revendication 4, **caractérisé en ce que** ledit procédé d'oxydation est un procédé thermique.

6. Procédé de fabrication de pièces (24) selon l'une des revendications 4 et 5, **caractérisé en ce que** ladite formation d'un bourrelet (44) en oxyde en pourtour de ladite couche superficielle (18) d'oxyde est réalisée par un procédé d'oxydation sélective du pourtour de ladite couche superficielle (16) de silicium.

7. Procédé de fabrication de pièces (24) selon la revendication 6, **caractérisé en ce que** ledit procédé d'oxydation sélective du pourtour de ladite couche superficielle (16) de silicium comporte une étape d'application d'un masque (42) sur une zone centrale de ladite couche superficielle (18) d'oxyde, suivie d'une étape d'oxydation thermique, ledit masque (42) étant apte à s'opposer à ladite oxydation thermique.

8. Procédé de fabrication de pièces (24) selon la revendication 7, **caractérisé en ce que** ledit masque (42) est réalisé par dépôt d'une couche de nitrure (40) sur ladite couche superficielle (18) d'oxyde, suivi d'une structuration de ladite couche de nitrure de manière à éliminer le pourtour de ladite couche de nitrure (40).

9. Procédé de fabrication de pièces (24) selon les revendications 2 à 8, **caractérisé en ce que** ladite découpe des pièces (24) en silicium est réalisée par un procédé d'attaque assisté par plasma.

10. Procédé de fabrication de pièces (24) selon l'une des revendications 1 à 9, **caractérisé en ce qu'**il comprend, en outre, une étape de séparation desdites pièces (24) dudit substrat (10).

## Claims

1. Method of manufacturing parts (24) or a first material able to be etched, from a substrate (10) including at least one superficial layer (16) of said first material, **characterized in that** it includes the following steps:
- forming a substantially uniform superficial layer (18) of a second material at the surface of said superficial layer (16) of the first material, said second material being able to resist a selective etch of the first material,
- forming a bead (44) of said second material at the periphery of said superficial layer (18) of said second material,
- structuring the layer (18) of second material and the bead (44) by a standard photolithographic process including an etch step of sufficient duration to etch the superficial layer (18) of second material over the entire thickness thereof, but insufficient to etch said bead (44) over the entire thickness thereof, so as to obtain a mask (20) of said second material extending as far as the periphery of said layer (16) of first material,
- cutting out the parts made of the first material through said mask (20) of said second material, by directional etching.

2. Method of manufacturing parts (24) according to claim 1, **characterized in that** said first material is silicon.

3. Method of manufacturing parts (24) according to any of claims 1 or 2, **characterized in that** said second material is oxide.

4. Method of manufacturing parts (24) according to claims 2 and 3, **characterized in that** the superficial oxide layer (18) is formed at the surface of the superficial silicon layer (16) by a full oxidation method of said superficial silicon layer (16).

5. Method of manufacturing parts (24) according to claim 4, **characterized in that** said oxidation method is a thermal method.

6. Method of manufacturing parts (24) according to any of claims 4 or 5, **characterized in that** said oxide bead at the periphery of said superficial oxide layer (18) is formed by a selective oxidation method of the periphery of said superficial silicon layer (16).

7. Method of manufacturing parts (24) according to claim 6, **characterized in that** said selective oxidation method of the periphery of said superficial silicon layer (16) includes a step of applying a mask (42) to a central zone of said superficial oxide layer (18), followed by a thermal oxidation step, said mask (42) being able to resist said thermal oxidation.

8. Method of manufacturing parts (24) according to claim 7, **characterized in that** said mask (42) is made by depositing a nitride layer (40) on said superficial oxide layer (18), followed by the structuring of said nitride layer so as to remove the periphery of said nitride layer (40).

9. Method of manufacturing parts (24) according to claims 2 to 8, **characterized in that** said silicon parts (24) are cut out by a plasma assisted etching method.

10. Method of manufacturing parts (24) according to any of claims 1 to 9, **characterized in that** it further includes a step of separating said parts (24) from said substrate (10).

## Patentansprüche

1. Verfahren zur Herstellung von Teilen (24) aus einem ersten ätzbaren Material, ausgehend von einem Substrat (10) umfassend wenigstens eine oberflächliche Schicht (16) aus dem besagten ersten Material, **dadurch gekennzeichnet, dass** das Verfahren folgende Schritte umfasst:
- Ausformung einer im Wesentlichen uniformen oberflächlichen Schicht (18) aus einem zweiten Material auf der Oberfläche der besagten ersten oberflächlichen Schicht (16) aus dem ersten Material, wobei das besagte zweite Material dem selektiven Ätzen des besagten ersten Material widerstehen kann,
- Ausformung einer Verdickung (44) aus dem besagten zweiten Material am Umfang der besagten oberflächlichen Schicht (18) des besagten zweiten Materials,
- Strukturierung der besagten Schicht (18) des zweiten Material und der Verdickung (44) durch ein gewöhnliches Photolithographieverfahren, das einen Ätzsschritt während einer Dauer umfasst, die für das Ätzen der oberflächlichen Schicht (18) des besagten zweiten Material durch ihre gesamte Dicke ausreicht, aber nicht für das Ätzen der besagten Verdickung (44) durch ihre gesamte Dicke ausreicht, so dass eine Maske (20) aus dem besagten zweiten Material geformt wird, die sich bis zum äusseren Rand der besagten Schicht (16) erstreckt,
- Ausschneiden der besagten Teile aus dem besagten ersten Material, durch gerichtete Ätzung durch die besagte Maske (20) aus dem besagten zweiten Material.

2. Verfahren zur Herstellung von Teilen (24) gemäss Anspruch 1, **dadurch gekennzeichnet, dass** das besagte erste Material Silizium ist.

3. Verfahren zur Herstellung von Teilen (24) gemäss Anspruch 1 oder 2, **dadurch gekennzeichnet, dass** das besagte zweite Material ein Oxid ist.

4. Verfahren zur Herstellung von Teilen (24) gemäss Anspruch 2 und 3, **dadurch gekennzeichnet, dass** die oberflächliche Oxidschicht (18) auf der Oberfläche der oberflächlichen Siliziumschicht (16) durch ein volles Oxidierungsverfahren der besagten oberflächlichen Siliziumschicht (16) geformt ist.

5. Verfahren zur Herstellung von Teilen (24) gemäss Anspruch 4, **dadurch gekennzeichnet, dass** das besagte Oxidierungsverfahren ein thermisches Verfahren ist.

6. Verfahren zur Herstellung von Teilen (24) gemäss Anspruch 4 oder 5, **dadurch gekennzeichnet, dass** die besagte Oxidverdickung am Rande der besagten oberflächlichen Schicht (18) durch ein selektives Oxidierungsverfahren des Randes der besagten oberflächlichen Siliziumschicht (16) geformt ist.

7. Verfahren zur Herstellung von Teilen (24) gemäss Anspruch 6, **dadurch gekennzeichnet, dass** das besagte selektive Oxidierungsverfahren des Randes der besagten oberflächlichen Siliziumschicht (16) einen Schritt umfasst, bei dem eine Maske (42) auf der zentralen Zone des besagten oberflächlichen Oxidschicht (18) angebracht ist, und anschliessend einen thermischen Oxidierungsschritt umfasst, wobei die besagte Maske (42) der thermischen Oxidierung widerstehen kann.

8. Verfahren zur Herstellung von Teilen (24) gemäß Anspruch 7, **dadurch gekennzeichnet, dass** die besagte Maske (42) durch folgende Herstellungsschritte realisiert ist:
- ablagern einer Nitridschicht auf der besagten oberflächlichen Oxidschicht
- anschließend Strukturierung der besagten Nitridschicht, um den Rand der besagten Nitridschicht zu entfernen.

9. Verfahren zur Herstellung von Teilen (24) gemäß einem der Ansprüche 2 bis 8, **dadurch gekennzeichnet, dass** die besagten Siliziumteile (24) durch ein Plasma-unterstütztes Ätzsverfahren ausgeschnitten sind.

10. Verfahren zur Herstellung von Teilen (24) gemäss einem der Ansprüche 1 bis 9, **dadurch gekennzeichnet, dass** es ferner einen Trennungsschritt der besagten Teile (24) von dem besagten Substrat (10) aufweist.
